(19)
<br>

Europäisches Patentamt

European Patent Office

Office européen des brevets

(11) **EP 4 541 586 A1**

(12) **EUROPEAN PATENT APPLICATION**
published in accordance with Art. 153(4) EPC

(43) Date of publication:
**23.04.2025 Bulletin 2025/17**

(21) Application number: **23823591.5**

(22) Date of filing: **16.05.2023**

(51) International Patent Classification (IPC):
**B32B 27/18** (2006.01) **B29C 45/14** (2006.01)
**H05K 9/00** (2006.01)

(52) Cooperative Patent Classification (CPC):
**B29C 45/14; B32B 27/18; H05K 9/00**

(86) International application number:
**PCT/JP2023/018267**

(87) International publication number:
**WO 2023/243290 (21.12.2023 Gazette 2023/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **16.06.2022 JP 2022096985**

(71) Applicant: **Toray Industries, Inc.**
**Tokyo 103-8666 (JP)**

(72) Inventor: **KITAMURA, Yutaka**
**Otsu-shi, Shiga 520-2141 (JP)**

(74) Representative: **Kador & Partner Part mbB**
**Corneliusstraße 15**
**80469 München (DE)**

(54) **IN-MOLD TRANSFER MOLDING FILM AND METHOD FOR MANUFACTURING MOLDED ARTICLE**

(57) Provided is an in-mold transfer molding film, which has excellent moldability, post-molding electroconductivity and electromagnetic wave shielding properties and that features good productivity. Also provided is a method for manufacturing a molded article. The in-mold transfer molding film comprises a substrate film, a release layer, and an electroconductive layer, in this order. The electroconductive layer contains, with respect to the electroconductive layer which is 100 mass%, particles at 60-91 mass%, and contains a resin at 9-40 mass%. The weight average molecular weight of the resin is at least 5,000 but less than 10,000. The particles include at least one type selected from the group consisting of non-valent carbon, silver, gold, copper, nickel, chrome, palladium, indium, aluminum, zinc and platinum.

EP 4 541 586 A1

**Description**

TECHNICAL FIELD

The invention relates to a molding film for in-mold transfer and a method for producing a molded article.

BACKGROUND ART

In recent years, as the IoT society expands, there has been an increasing demand for instruments with high electromagnetic wave shielding capability in various fields such as mobile phones, electric appliances, and automotive parts. When using resin for housings, there are known methods for processing molded articles such as plating and conductive coating. However, these conventional methods require environment countermeasures such as wastewater processing and post-treatment of solvents, and various attempts are being made aiming to make improvements in this area.

For example, Patent document 1 discloses a technique for in-mold transfer processing using a molding film with a conductive layer that contains resin and conductive fine particles. Patent document 2 discloses a technology related to a molding film for in-mold transfer that has a conductive layer containing metal, conductive polymer resin, etc.

PRIOR ART DOCUMENTS

PATENT DOCUMENTS

Patent document 1: Japanese Unexamined Patent Publication (Kokai) No. 2021-192960
Patent document 2: Japanese Unexamined Patent Publication (Kokai) No. 2006-297642

SUMMARY OF INVENTION

PROBLEMS TO BE SOLVED BY THE INVENTION

However, the technique described in Patent document 1 has problems such as in-plane variation in the conductive layer that occur when it is applied to a in-mold transfer process, leading to deterioration in conductivity and electromagnetic wave shielding capability. On the other hand, the technique described in Patent document 2 has problems in terms of moldability since cracks and breakages can occur in the conductive layer when it is applied to the production of a molded article having a complex shape.

The main object of the present invention is to solve these problems with the conventional technology by providing a molding film for in-mold transfer that is high in moldability and also high in post-molding conductivity and electromagnetic wave shielding capability and ensures high productivity and also by providing a method for producing molded articles.

MEANS OF SOLVING THE PROBLEMS

The inventors of the present invention have arrived at this invention after making intensive studies for solving the above problems and finding that the problems can be solved as described below. Specifically, the molding film for in-mold transfer and the production method for molded articles according to a preferred embodiment of the present invention have configurations as described below.

(1) A molding film for in-mold transfer comprising a substrate film, a release layer, and a conductive layer disposed in this order, wherein the conductive layer contains particles in an amount of 60 mass% or more and 91 mass% or less in 100 mass% of the conductive layer, the conductive layer also containing resin in an amount of 9 mass% or more and 40 mass% or less, the resin having a weight average molecular weight of 5,000 or more and less than 10,000, and the particles being made of one or more substances selected from the group consisting of zero-valent carbon, silver, gold, copper, nickel, chromium, palladium, indium, aluminum, zinc, and platinum.

(2) The molding film for in-mold transfer according to (1), wherein the conductive layer has a thickness of 5 $\mu$m or more and 15 $\mu$m or less.

(3) The molding film for in-mold transfer according to either (1) or (2), wherein the conductive layer exhibits a glass transition temperature of 40°C or more and 100°C or less when heated from 20°C to 250°C at a rate of 20°C/min in a nitrogen atmosphere in a differential scanning calorimeter.

(4) The molding film for in-mold transfer according to any one of (1) to (3), comprising the substrate film, the release layer, the conductive layer, and an adhesive layer disposed in this order.

(5) The molding film for in-mold transfer according to any one of (1) to (4), wherein the release layer contains silicone resin as primary component.

(6) The molding film for in-mold transfer according to (5), wherein the release layer contains an alkyd modified silicone resin as primary component.

(7) The molding film for in-mold transfer according to any one of (1) to (6), wherein the resin is polyester resin.

(8) The molding film for in-mold transfer according to (7), wherein the polyester resin has an acid value of 5 mgKOH/g or more and 20 mgKOH/g or less.

(9) The molding film for in-mold transfer according to any one of (1) to (8), wherein the particles include first type particles having an aspect ratio of 1 or more and less than 2 and second type particles having an aspect ratio of 2 or more.

(10) The molding film for in-mold transfer according to any one of (1) to (9), showing an electromagnetic wave shielding capability of 40 dB or more when the molding film for in-mold transfer is examined by the KEC method (electric field) for electromagnetic waves with a frequency of 300 MHz.

(11) The molding film for in-mold transfer according to any one of (1) to (10), wherein the substrate film is a polyethylene terephthalate film.

(12) A production method for molded articles comprising a step for placing the molding film for in-mold transfer according to any one of (1) to (11) in a mold cavity and then injecting a molding resin and/or a molding resin precursor.

ADVANTAGEOUS EFFECTS OF THE INVENTION

The present invention can provide a molding film for in-mold transfer that is high in moldability and also high in post-molding conductivity and electromagnetic wave shielding capability and ensures high productivity and also provide a production method for molded articles.

DESCRIPTION OF PREFERRED EMBODIMENTS

The molding film for in-mold transfer according to a preferred embodiment of the present invention includes a substrate film, a release layer, and a conductive layer disposed in this order, wherein the conductive layer contains particles in an amount of 60 mass% or more and 91 mass% or less in 100 mass% of the conductive layer, the conductive layer also containing resin in an amount of 9 mass% or more and 40 mass% or less, the resin having a weight average molecular weight of 5,000 or more and less than 10,000, and the particles being made of one or more substances selected from the group consisting of zero-valent carbon, silver, gold, copper, nickel, chromium, palladium, indium, aluminum, zinc, and platinum. The molding film for in-mold transfer according to the present invention is described in more detail below.

[Conductive layer]

The conductive layer according to a preferred embodiment of the present invention contains particles in an amount of 60 mass% or more and 91 mass% or less in 100 mass% of the conductive layer and the conductive layer also contains resin in an amount of 9 mass% or more and 40 mass% or less. If they are configured in this way, the conductive layer will suffer no fine cracks and have a high moldability even after undergoing a step in which it is heated for molding.

Furthermore, the resin has a weight average molecular weight of 5,000 or more and less than 10,000, and the particles are made of one or more substances selected from the group consisting of zero-valent carbon, silver, gold, copper, nickel, chromium, palladium, indium, aluminum, zinc, and platinum, which allows the conductive layer to suffer less in-plane variation even after undergoing a step in which it is heated for molding, thereby leading to a molded article that is high in post-molding conductivity and electromagnetic wave shielding capability.

From the above perspective, if particles are included in an amount of 60 mass% or more, the content of particles in the conductive layer can be increased, accordingly leading to a high post-molding conductivity and electromagnetic wave shielding capability. From the same perspective, it is more preferable that they are included in an amount of 65 mass% or more, and still more preferably in an amount of 70 mass% or more.

On the other hand, if particles are included in an amount of 91 mass% or less, the content of resin in the conductive layer can be increased, accordingly leading to a higher moldability. From the same perspective, it is more preferable that they are included in an amount of 87 mass% or less, and still more preferably in an amount of 85 mass% or less.

From the above perspective, it is more preferable that the particles used for the present invention are included in an amount of 65 mass% or more and 87 mass% or less, and still more preferably in an amount of 70 mass% or more and 85 mass% or less of all components present in the conductive layer, which account for 100 mass%.

From the perspective of ensuring a high post-molding conductivity and electromagnetic wave shielding capability, it is preferable for the particles used for the present invention to be made of one or more substances selected from the group consisting of zero-valent carbon, silver, gold, copper, nickel, chromium, palladium, indium, aluminum, zinc, and platinum. In view of the fact the conductivity and electromagnetic wave shielding capability improve as the resistivity decreases, it is more preferable that they are made of one or more substances selected from the group consisting of gold, silver, silver-plated copper powder, and an alloy of silver and copper. It should be noted that "zero-valent" applies not only to carbon alone, but to all listed metal elements.

Whether particles as mentioned above contain a zero-valent metal element can be determined by preparing a cross-sectional specimen by cutting the molding film for in-mold transfer and subjecting it to energy dispersive X-ray spectroscopy mapping analysis (hereinafter EDX mapping analysis) to see if a zero-valent metal element is detected in the particle regions. EDX mapping analysis may be performed, for example, by using a scanning electron microscope (XL30 SFEG, manufactured by FEI Company) equipped with an energy dispersive X-ray spectrometer (NEW XL30 132-2.5, manufactured by EDAX) under the conditions of an acceleration voltage of 20 kV and a magnification of 20,000x. In addition, cutting of a molding film for in-mold transfer can be performed, for example, by using a Cross Section Polisher (registered trademark) SM-09010 (manufactured by JEOL Ltd.). When using this equipment, a sample is prepared by treating the film for 10 hours with argon gas at an acceleration voltage of 4 kV and a current of 70 $\mu$A. For carbon particles, furthermore, qualitative analysis is carried out to examine a cross-sectional specimen prepared by the same procedure as described above and subjecting it to micro-Raman mapping analysis. For micro-Raman mapping analysis, measurement can be performed, for example, by using a laser micro-Raman spectroscopy apparatus (LabRAM (registered trademark) HR Evolution, manufactured by Horiba Ltd.).

If the particles include first type particles having an aspect ratio of 1 or more and less than 2 and second type particles having an aspect ratio of 2 or more, overlapping of particles can be maintained in the conductive layer in the molded article, accordingly leading to a further increased post-molding electromagnetic wave shielding capability.

From the same perspective as described above, it is preferable that the first type particles account for 20 mass% or more and 70 mass% or less and that the second type particles account for 10 mass% or more and 60 mass% or less, of all components present in the conductive layer, which account for 100 mass%.

It should be noted that for the present invention, particles mean primary particles. Accordingly, the first type particles are primary particles having an aspect ratio of 1 or more and less than 2, and the second type particles are primary particles having an aspect ratio of 2 or more. Available methods for determining the average particle diameter of primary particles include, for example, the use of a scattering type particle diameter distribution measuring device (LA-960V2, manufactured by Horiba, Ltd.).

The aspect ratio of particles referred to herein can be calculated as the ratio of the average long diameter to the average short diameter of the particles. To determine the ratio "the average long diameter / the average short diameter" of the particles, for example, a cross section of the conductive layer is prepared by cutting the molding film for in-mold transfer and observed under a scanning electron microscope (XL30 SFEG, manufactured by FEI Company) at an acceleration voltage of 20 kV and a magnification of 100,000x. From the image taken, 50 particles are selected and each of them is approximated as an ellipse. The aspect ratio is calculated on the assumption that the averages of maximum lengths and the averages of minimum lengths represent the average major axis and the average minor axis, respectively. Furthermore, cutting of a molding film for in-mold transfer can be carried out, for example, by using a manual type rotary microtome (HistoCore BIOCUT (registered trademark) R, manufactured by Leica Microsystems).

In addition, if the resin accounts for 40 mass% or less, the proportion of particles to all components present in the conductive layer can be increased, accordingly leading to an increased post-molding conductivity and electromagnetic wave shielding capability. From the same perspective, the resin more preferably accounts for 25 mass% or less, and still more preferably accounts for 20 mass% or less.

On the other hand, if the resin accounts for 9 mass% or more, it can enhance the dispersion of particles in the conductive layer and increase the overall moldability and flexibility of the conductive layer, accordingly leading to a higher moldability. From the same perspective, the resin more preferably accounts for 10 mass% or more, and still more preferably accounts for 13 mass% or more.

From the above perspective, the resin used for the present invention more preferably accounts for 10 mass% or more and 25 mass% or less and still more preferably accounts for 13 mass% or more and 20 mass% or less in 100 mass% of the conductive layer.

To ensure higher moldability as well as higher post-molding conductivity and electromagnetic wave shielding capability, it is preferable that the resin has a weight average molecular weight of 5,000 or more and less than 10,000.

If the resin has a weight average molecular weight of 5,000 or more, the viscosity of the resin increases to ensure stable flow properties of the conductive layer during the molding step, leading to a reduction in in-plane variation in the conductive layer. This ensures a high conductivity and electromagnetic wave shielding capability. From the same perspective, it is more preferable for the resin to have a weight average molecular weight of 7,500 or more.

Furthermore, if the weight average molecular weight of the resin is less than 10,000, the flowability of the resin during the molding step increases to ensure a high moldability. From the same perspective, it is more preferable for the resin to have a weight average molecular weight of 9,000 or less, still more preferably 8,500 or less.

From the above perspective, it is more preferable for the resin used for the present invention to have a weight average molecular weight of 7,500 or more and 9,000 or less.

The weight average molecular weight of resin can be determined from the styrene based molecular weight on the basis of molecular weight distribution measurement performed by gel permeation chromatography (GPC). The procedure for measuring the weight average molecular weight of resin by GPC is described below.

Using a high speed GPC instrument (HLC-8220, manufactured by Tosoh Corporation) equipped with two separation columns (PLgel 5 $\mu$m MiniMIX-D, manufactured by Agilent Technologies) connected in series as the measuring apparatus, a calibration curve is formed by preparing a solution of chloroform containing a polystyrene standard (with a weight average molecular weight of 5,000, 10,000, or 30,000) as standard sample, stirring it at 20°C for 10 minutes, filtering it through a 0.45 $\mu$m membrane filter, and examining the resulting standard sample solution. Then, 5 mg of the conductive layer is put in 2 mL of chloroform and the solution is stirred at 20°C for 10 minutes and filtered through a 0.45 $\mu$m membrane filter. The resulting test specimen is examined to determine the weight average molecular weight of the resin. In this step, the flow rate in the separation column is set to 0.35 mL/min, and the column temperature is adjusted to 40°C. A differential refractometer (RI detector, manufactured by Tosoh Corporation) is used as detector. Here, the liquid is sampled at each peak and weighed to make it possible to determine the content of the resin at each peak.

To ensure a higher moldability as well as higher post-molding conductivity and electromagnetic wave shielding capability, it is preferable that the glass transition temperature measured is 40°C or more and 100°C or less when the conductive layer used for the present invention is heated from 20°C to 250°C at a rate of 20°C/min in a nitrogen atmosphere in a differential scanning calorimeter.

If the glass transition temperature of the conductive layer measured above is 100°C or less, it can exhibit a sufficient flexibility during the molding step, leading to a high moldability. From the same perspective, it is more preferable that the glass transition temperature of the conductive layer measured above is 80°C or less.

On the other hand, if the glass transition temperature of the conductive layer measured above is 40°C or more, it ensures stable flow properties of the conductive layer during the molding step, leading to a reduction in in-plane variation in the conductive layer. This leads to a high post-molding conductivity and electromagnetic wave shielding capability. From the above perspective, it is more preferable that the glass transition temperature of the conductive layer measured above is 60°C or more.

From these perspectives, it is more preferable, for the present invention, that the glass transition temperature of the conductive layer measured above is 60°C or more and 80°C or less.

The glass transition temperature of the conductive layer can be measured by using a generally known differential scanning calorimeter. More specifically, measurement of the glass transition temperature of a conductive layer by means of a differential scanning calorimeter is performed using a differential scanning calorimeter (RDC220, manufactured by Seiko Instruments Inc.) according to the measurement and analysis procedure specified in JIS K7121 (2012) as described below.

Only the conductive layer is scraped off from the molding film for in-mold transfer under analysis, and the conductive layer obtained is heated in a nitrogen atmosphere at 100°C for 4 hours and then cooled to 25°C to prepare a 5 mg sample. As the sample is heated from 20°C to 250°C at a rate of 20°C/min in a nitrogen atmosphere, the change in specific heat caused by the transition from a glass state to a rubber state is observed. The midpoint glass transition temperature, which is the temperature at the point where the straight line that is equidistant in the vertical axis (showing the heat flow) direction from the linear extensions of the baselines intersects the curve of the step-like portion that shows glass transition, is measured and adopted as the glass transition temperature.

To ensure a higher moldability as well as a higher post-molding conductivity and electromagnetic wave shielding capability, it is preferable that the resin present in the conductive layer contains polyester resin as primary component. Here, the expression "the resin present in the conductive layer contains polyester resin as primary component" means that polyester resin accounts for 50 mass% or more of the total content of the resin present in the conductive layer, which accounts for 100 mass%. According to this embodiment, the flexibility of the resin and the dispersion of the particles can be improved, thereby ensuring a high moldability as well as a high post-molding conductivity and electromagnetic wave shielding capability. From the same perspective, it is preferable that the polyester resin accounts for 80 mass% or more of the total content of the resin, which accounts for 100 mass%. In addition, from the above perspective, it is more preferable that the resin present in the conductive layer is polyester resin. From the same perspective, furthermore, it is preferable that the polyester resin is a saturated polyester resin, and from the perspective of durability, it is more preferable that the polyester resin is a thermoplastic saturated polyester resin.

To ensure a higher moldability as well as a higher post-molding conductivity and electromagnetic wave shielding capability, it is preferable for the polyester resin to have an acid value of 5 mgKOH/g or more and 20 mgKOH/g or less.

If the polyester resin has an acid value of 5 mgKOH/g or more, it works to improve adhesion with the release layer and accordingly reduce the in-plane variation in the conductive layer obtained after the molding step, leading to a higher conductivity and electromagnetic wave shielding capability. From the same perspective, it is more preferable for the polyester resin to have an acid value of 7 mgKOH/g or more.

On the other hand, if the polyester resin has an acid value of 20 mgKOH/g or less, it works to improve the dispersion of the particles and the polyester resin, accordingly leading to a higher moldability. From the same perspective, it is more preferable for the polyester resin to have an acid value of 15 mgKOH/g or less.

From the above perspective, it is more preferable that the polyester resin has an acid value of 5 mgKOH/g or more and 20 mgKOH/g or less and has a weight average molecular weight of 7,500 or more and 9,000 or less.

Good methods for qualitative and quantitative analysis of polyester resin include, for example, scraping off only the conductive layer from the molding film for in-mold transfer under examination and then freeze-drying the conductive layer sample obtained, followed by subjecting the recovered dried solid sample to qualitative and quantitative analysis by means of a gas chromatography-mass spectrometry (P&T-GC/MS) apparatus equipped with a purge and trap sampler (thermal desorption device).

The acid value of a polyester resin can be determined by the titration method specified in JIS K 5601-2-1 (1999). Specifically, for example, a sample is dissolved in a mixed solvent of toluene and ethanol blended at a volume ratio of 2/1, titrated with a potassium hydroxide solution using phenolphthalein as an indicator, and the acid value is calculated by the following formula according to the titration method specified in JIS K 5601-2-1 (1999).

$$\text{Acid value (mgKOH/g)} = 56.1 \times V \times C/m$$

wherein V denotes the titration volume (ml); C denotes the concentration of the titrant (mol/l); and m denotes the solid content by mass of the sample (g).

In order to ensure a required post-molding conductivity and electromagnetic wave shielding capability, it is preferable that the conductive layer used for the present invention has a thickness of 5 $\mu$m or more and 15 $\mu$m or less. If the thickness of the conductive layer is 15 $\mu$m or less, it ensures stable heating of the conductive layer during the molding step and this serves to reduce the in-plane variation in the conductive layer, thereby leading to a high post-molding conductivity and electromagnetic wave shielding capability. From the same perspective, it is preferable that the conductive layer has a thickness of 12 $\mu$m or less. On the other hand, if the thickness of the conductive layer is 5 $\mu$m or more, it ensures an increase in the content of particles in the conductive layer and a decrease in the resistivity of the conductive layer, and accordingly, it enhances the conductivity and electromagnetic wave shielding capability sufficiently, thereby leading to a high post-molding conductivity and electromagnetic wave shielding capability. From the same perspective, it is more preferable for the conductive layer to have a thickness of 7 $\mu$m or more.

[Electromagnetic wave shielding capability]

Being configured in this way, the molding film for in-mold transfer according to the present invention can have an electromagnetic wave shielding capability of 40 dB or more as measured by the KEC method (electric field) for electromagnetic waves with a frequency of 300 MHz.

The KEC method is a measuring method developed by KEC Electronic Industry Development Center, which consists of two units for electromagnetic wave generated in near fields; one for evaluation of electric field shielding effect and the other for magnetic field shielding effect. Measurement by this method can be performed by transmitting electromagnetic waves from a transmission antenna (jig for transmission), allowing the electromagnetic waves to pass through an electromagnetic wave shielding film (sample for measurement), and receiving them on a receiving antenna (jig for reception). In performing this KEC method, electromagnetic waves are passed (transmitted) through an electromagnetic wave shielding film and then measured on a receiving antenna. Specifically, the degree of attenuation of the transmitted electromagnetic waves (signals) caused by the electromagnetic wave shielding film is measured on the receiving antenna, and the electromagnetic wave shielding capability to block (shield) the electromagnetic waves is determined by combining the reflected component of the electromagnetic waves and the absorbed component of the electromagnetic waves.

The molding film for in-mold transfer according to the present invention preferably has an electromagnetic wave shielding capability of 40 dB or more as measured by the KEC method (electric field) for electromagnetic waves with a frequency of 300 MHz.

[Release layer]

The release layer to use for the present invention is not particularly limited as long as it works as a layer for separating the conductive layer and the substrate film, but it is preferable that the layer contains silicone resin as primary component from the perspective of ensuring high productivity. If the release layer contains silicone resin as primary component, or more preferably, if silicone resin accounts for 80 mass% or more in the release layer, it allows the adhesion between the substrate film and the conductive layer to be controlled, thereby ensuring both a high processability of the conductive layer and a high peelability of the substrate film during the molding step.

From the perspective of controlling the adhesion with the conductive layer, more preferable examples of the silicone resin include silicones modified by graft polymerization with organic resins etc. such as polyester modified silicone resin, acrylic modified silicone resin, urethane modified silicone resin, epoxy modified silicone resin, and alkyd modified silicone resin, of which alkyd modified silicone resin is still more preferable from the perspective of controlling the adhesion with polyester resin.

[Substrate film]

From the perspective of having high dimensional stability and durability and ensuing improved productivity, it is preferable that the substrate film to use for the present invention is a polyester film, and preferable examples thereof include plastic films of polyethylene terephthalate, polyethylene 2,6-naphthalate, polyethylene $\alpha,\beta$-bis(2-chlorophenoxy) ethane-4,4'-dicarboxylate, and polybutylene terephthalate. Of these, the use of a polyethylene terephthalate film is particularly preferable due to its suitability for lamination with a release layer and a conductive layer and its high processability during the molding step. From the same perspective, the use of a biaxially oriented polyethylene terephthalate film is the most preferable.

[Molding film for in-mold transfer]

The molding film for in-mold transfer according to the present invention is high in moldability and also high in post-molding conductivity and electromagnetic wave shielding capability and accordingly serves for easy production of molded articles with curved surfaces, concave-convex ribs, hinges, bosses, or hollow shapes that are high in conductivity or have good electromagnetic wave shielding layers. More specifically, because of being small in in-plane variation in conductivity and electromagnetic wave shielding capability, it can be used more suitably as a molding film for in-mold transfer intended to produce molded products having conductivity and electromagnetic wave shielding capability. In particular, being small in-plane variation in electromagnetic wave shielding capability, it can be used still more suitably as a molding film for in-mold transfer for producing molded products having electromagnetic wave shielding capability.

From the above perspective, it can be used suitably to impart electromagnetic wave shielding capability to various products including personal computers, displays, office automation equipment, mobile phones, portable information devices, optical equipment, audio equipment, air conditioners, lighting equipment, entertainment devices, toys, other household appliances, electronic devices, semiconductor components, electrical components/interior parts of automobiles, electrical components/interior parts of aircraft, and electrical components/interior parts of motorcycles, although the present invention is not limited to these applications as long as its preferred effects are not impaired.

From the perspective of adhering the conductive layer to resin and/or resin precursor, the molding film for in-mold transfer according to the present invention preferably includes a substrate film, a release layer, a conductive layer, and an adhesive layer disposed in this order, and it is more preferable that the adhesive layer is the outermost layer.

The resin to use for the adhesive layer in the molding film for in-mold transfer according to the present invention, i.e., the resin contained in the adhesive layer, may be either a heat-sensitive resin or a pressure-sensitive resin, and an appropriate adhesive layer material may be adopted to suit the resin and/or resin precursor.

Preferable examples of the resin contained in the adhesive layer include acrylic resins, polyester based resins, polyphenylene oxide-polystyrene based resins, polycarbonate based resins, polystyrene based resins, styrene copolymer based resins, polyamide based resins, chlorinated polyolefin based resins, chlorinated vinyl acetate copolymer based resins, cyclized rubbers, and coumarone-indene based resins, which may be used singly or in combination.

[Production method for molding film for in-mold transfer]

To produce a molding film for in-mold transfer, the materials, quantities, processing steps, and processing procedures, etc., listed below as examples may be used.

The molding film for in-mold transfer according to the present invention can be prepared, for example, by coating one side of a substrate film with a coating material composition for forming a release layer and coating it with a coating material composition for forming a conductive layer in this order, followed by heat treatment.

For the present invention, such a coating material composition for forming a release layer can be prepared by mixing a silicone resin and an organic solvent. The organic solvent to use in the coating material composition for forming the release layer for the present invention preferably accounts for 50 mass% or more and 99 mass% or less of all components of the resin mixture including the silicone resin and the organic solvent, which account for 100 mass%, from the perspective of ensuring a high coatability on the substrate film. From the perspective of improving the coatability of the coating material composition for forming the release layer, good organic solvents include, for example, ethyl methyl ketone, methyl isobutyl ketone, butyl acetate, ethyl acetate, methanol, isopropanol, cyclohexanone, toluene, and xylene. Furthermore, from the perspective of preventing the blocking between film layers in film rolls and improving the coatability on the substrate film, the coating material composition may include inorganic particles, organic particles, leveling agents, etc., as long as preferred effects of the present invention are not impaired.

For the present invention, such a coating material composition for forming a conductive layer can be produced by first mixing particles, resin, and an organic solvent for mixing to prepare a resin mixture and then adding an organic solvent for dilution. The particles to use in the resin mixture for the present invention preferably account for 60 mass% or more and 91 mass% or less of all components thereof including the particles and resin, which account for 100 mass%. Furthermore, the resin to use in the resin mixture for the present invention preferably accounts for 9 mass% or more and 40 mass% or less of all components thereof including the particles and resin, which account for 100 mass%. The organic solvent for mixing to use in the resin mixture for forming a conductive layer for the present invention preferably accounts for 5 mass% or more and 50 mass% or less of all components of the resin mixture including the particles, resin, and the organic solvent for mixing, which account for 100 mass%, from the perspective of ensuring good mixing dispersion of the particles and resin. From the perspective of preventing evaporation of the organic solvent for mixing and suppressing an increase in the viscosity of the resin mixture at the time of mixing particles and resin, preferable examples of the organic solvent for mixing include N,N-dimethylacetamide, N,N-dimethylformamide, N-methyl-2-pyrrolidone, dimethylimidazolidinone, dimethyl-sulfoxide, $\gamma$-butyrolactone, ethyl lactate, 1-methoxy-2-propanol, 1-ethoxy-2-propanol, ethylene glycol mono-n-propyl ether, diacetone alcohol, tetrahydrofurfuryl alcohol, propylene glycol monomethyl ether acetate, diethylene glycol monoethyl ether acetate, diethylene glycol monomethyl ether, diethylene glycol monoethyl ether acetate (hereinafter DMEA), diethylene glycol monobutyl ether, diethylene glycol, and 2,2,4,-trimethyl-1,3-pentanediol monoisobutyrate, which may be used singly or in combination.

The organic solvent for dilution to use for the present invention preferably accounts for 10 mass% or more and 80 mass% or less of all components of the resin composition including the resin mixture and the organic solvent for dilution, which account for 100 mass, from the perspective of ensuring both a high coatability at he time of forming the conductive layer on the release layer and a required conductive layer thickness. Examples of the organic solvent for dilution include ethyl methyl ketone, methyl isobutyl ketone, butyl acetate, ethyl acetate, methanol, isopropanol, cyclohexanone, toluene, and xylene.

To prepare a resin mixture to use for the present invention by mixing it with particles, urethane resin, and an organic solvent for mixing, examples of good generally known mixing and dispersion methods include the use of a three-roll mill, ultrasonic disperser, sand mill, attritor, pearl mill, super mill, ball mill, impeller, disperser, KD mill, colloid mill, dynatron, planetary mill, or pressure kneader.

For the mixing of a resin mixture and an organic solvent for dilution to prepare the resin composition, good generally known mixing and dispersion methods include the use of a magnetic stirrer, Homodisper, ultrasonic wave irradiation, vibration-dispersion, and manual mixing and dispersion.

To spread a coating material composition for the release layer and a coating material composition for the conductive layer in this order on one side of a substrate film, it is preferable to use the comma coating method, applicator method, dip coating method, roller coating method, wire bar coating method, reverse coating method, kiss coating method, gravure coating method, or die coating method (as specified in U.S. Patent No. 2681294) to form a release layer and a conductive layer, of which the use of the applicator method, comma coating method, reverse coating method, or die coating method is more preferable from the perspective of processability.

The molding film for in-mold transfer according to the present invention is high in moldability and also high in post-molding conductivity and electromagnetic wave shielding capability and ensures high productivity, and accordingly, it can be used suitably for in-mold transfer processes.

Specifically, it is preferably applied to a production process for molded articles that includes a step in which the molding film for in-mold transfer is placed in a mold cavity first, followed by injecting resin and/or a resin precursor.

Such a process can be constructed using a generally known injection molding machine and film feeding device. For example, the S-2000 model apparatus (manufactured by Fanuc Corporation) can be used as the injection molding machine and a roll-type foil stamping machine (manufactured by Hori Metal Leaf & Powder Co., Ltd.) can be used as the film feeding device.

[Production method for molded articles; in-mold transfer process]

A production method for molded articles according a preferred embodiment of the present invention includes a step for placing the molding film for in-mold transfer in a mold cavity and then injecting a molding resin and/or a molding resin precursor.

Specifically, for example, it is preferable that the molding film for in-mold transfer according to the present invention is fed into the mold cavity of an injection molding machine and placed so that the conductive layer side of the molding film faces the cavity of a mold for in-mold transfer processing, and injection resin, adopted as molding resin and/or molding resin precursor, is injected and molded in such a manner that the conductive layer of the molding film is transferred onto the surface of the injection resin, followed by cooling the injection resin, opening the mold for injection molding, and peeling off the substrate film of the molding film to provide a molded article.

The molding resin and/or molding resin precursor to use for the present invention is preferably a thermoplastic resin or an elastomer, and more preferably, resins including polybutylene terephthalate (PBT), polyphenylene sulfide, polycarbonate, polyacetal, polyethylene terephthalate, polyphenylene oxide, polyacrylate, polyamide, polypropylene, acrylic resin, polystyrene, polyacrylonitrile-styrene, polyacrylonitrile-butadiene-styrene (ABS), and epoxy are used singly or in combination. In addition, glass fibers, inorganic fillers, etc., may be added appropriately to the resin as reinforcing materials

EXAMPLES

The present invention will be illustrated below in more detail with reference to examples, although the invention is not construed as being limited thereto.

Fist, the measuring methods and evaluation methods used in the examples are described below.

(1) Thickness of conductive layer and adhesive layer

The thicknesses ($\mu$m) of the conductive layer and the adhesive layer were measured by cutting a sample of the molding film for in-mold transfer perpendicularly to the thickness using a manual type rotary microtome (HistoCore BIOCUT (registered trademark) R, manufactured by Leica Microsystems) to prepare a cross-sectional specimen of the molding film for in-mold transfer and observing the cross section of the conductive layer using a scanning electron microscope (XL30 SFEG, manufactured by FEI Company) at an accelerating voltage of 20 kV and an observation magnification of 100,000x. The thickness was measured at five points randomly selected in the cross-sectional photograph and the average of the measurements taken was calculated.

(2) Aspect ratio of particles

In performing the procedure described in (1), 50 particles were extracted from the resulting scanning electron microscope image and each of them was approximated as an ellipse, followed by calculating the aspect ratio of each particle, wherein the maximum length and the minimum length were used as the major axis and the minor axis, respectively. Then, a histogram with intervals of 0.1 was created using the aspect ratios obtained, and the peak value was calculated as the aspect ratio of the second type particles. If there were two peaks, the smaller peak value was assumed to represent the aspect ratio of the first type particles whereas the larger peak value was assumed to represent the aspect ratio of the second type particles.

(3) Glass transition temperature of conductive layer

Measurement and analysis were carried out by using a differential scanning calorimeter (RDC220, manufactured by Seiko Instruments Inc.) according to the following procedure as specified in JIS K7121 (2012).

A 5 mg portion of a conductive layer or a thermoplastic resin was taken for use as a sample. When making an evaluation of a conductive layer or a thermoplastic resin, the conductive layer or the thermoplastic resin was heated in a nitrogen atmosphere at 100°C for 4 hours, and then cooled to 25°C, followed by preparing a 5 mg sample. As the sample was heated from 20°C to 250°C at a rate of 20°C/min in a nitrogen atmosphere, the change in specific heat caused by the transition from a glass state to a rubber state was observed. The midpoint glass transition temperature, which was the temperature at the point where the straight line that was equidistant in the vertical axis (showing the heat flow) direction from the linear extensions of the baselines intersects the curve of the step-like portion that shows glass transition, was measured and adopted as the glass transition temperature.

(4) Weight average molecular weight of resin

The molecular weight analysis of the thermoplastic resin contained in the conductive layer was carried out by the procedure described below, and the weight average molecular weight was determined from the peak area detected.

<Molecular weight analysis procedure>

Using a high speed GPC instrument (HLC-8220, manufactured by Tosoh Corporation) equipped with two separation columns (PLgel 5 μm MiniMIX-D, manufactured by Agilent Technologies Japan, Ltd.) connected in series as the measuring apparatus, a calibration curve was formed by preparing a solution of chloroform containing a polystyrene standard (with a weight average molecular weight of 5,000, 10,000, or 30,000) as standard sample, stirring it at 20°C for 10 minutes, filtering it through a 0.45 μm membrane filter, and examining the resulting standard sample solution. Then, 5 mg of the conductive layer was put in 2 mL of chloroform and the liquid was stirred at 20°C for 10 minutes and filtered through a 0.45 μm membrane filter, followed by subjecting the resulting test specimen to measurement. In this step, the flow rate in the separation column was set to 0.35 mL/min, and the column temperature was adjusted to 40°C. A differential refractometer (RI detector, manufactured by Tosoh Corporation) was used as detector.

(5) Electromagnetic wave shielding capability of molding film for in-mold transfer

A sample with a size of 120 mm × 120 mm was cut out of the molding film for in-mold transfer, and measurement was carried out by the KEC method (electric field). The electromagnetic wave shielding capability (dB) at a frequency of 300 MHz was calculated by a spectrum analyzer. As the results obtained show that the molding film for in-mold transfer works more effectively for electromagnetic wave shielding, it means that the film has higher electromagnetic wave shielding capability.

(6) Electromagnetic wave shielding capability of molding film for in-mold transfer extended at a ratio of 1.1 in length and 1.1 in width

The molding film for in-mold transfer was cut to a size of 120 mm × 120 mm, and the molding film for in-mold transfer was subjected to simultaneous biaxial stretching at ratios of 1.1 in length and 1.1 in width using a Labostretcher KARO 5.0 (manufactured by Bruckner) to prepare a sample. It was examined by the KEC method (electric field) and the electromagnetic wave shielding capability (dB) at a frequency of 1 GHz was measured with a spectrum analyzer. The measurement obtained was adopted as its electromagnetic wave shielding capability at a frequency of 1 GHz. A better electromagnetic wave shielding effect indicates a higher electromagnetic wave shielding capability.

(7) Processability in molding step

A film roll of the molding film for in-mold transfer was mounted on a film feeding device, namely a roll-type foil stamping machine (manufactured by Hori Metal Leaf & Powder Co., Ltd.), installed on an injection molding machine (ROBO SHOT S2000i 150A (manufactured by Fanuc Corporation) and then it was fed into the mold cavity of the injection molding machine and placed in such a manner that the conductive layer side of the molding film for in-mold transfer faced the cavity of the mold (for a tile-like molded article with a width of 30 mm, a length of 300 mm, and a height of 10 mm, temperature in processing step 80°C) of the in-mold transfer processing machine. Then, polybutylene terephthalate resin (Toraycon (registered trademark) 1101G, manufactured by Toray Industries, Inc.), referred to here as molding resin A, and polyacrylonitrile-butadiene-styrene resin (Toyolac (registered trademark) 100, manufactured by Toray Industries Inc.), referred to as molding resin B, were prepared. These molding resins, used as injection resins, were subjected to injection molding so that the conductive layer of the molding film for in-mold transfer was transferred onto the surface of the injection resins. After cooling, the mold for injection molding was opened, and then the substrate film of the molding film for in-mold transfer was peeled off to obtain a molded article. The processability for the molding step was evaluated according to the criteria described below based on the state of the conductive layer observed as the mold for injection molding was opened.
Here, in the case where the polybutylene terephthalate resin (Toraycon (registered trademark) 1101G, manufactured by Toray Industries, Inc.), namely, the molding resin A, was adopted, the melting temperature for the injection resin was set to 260°C and the injection speed and the cooling time used were 8 mm/s and 25 seconds, respectively, whereas in the case where the polyacrylonitrile-butadiene-styrene resin (Toyolac (registered trademark) 100, manufactured by Toray Industries, Inc.), namely, the molding resin B, was adopted, the injection resin melting temperature was set to 230°C and the injection speed and the cooling time used were 8 mm/s and 25 seconds, respectively.

A: No abnormalities were seen between the molded article and the substrate film, and the conductive layer was transferred to the surface of the molded article.
B: Unevenness in the conductive layer transferred onto the surface of the molded article was found after opening the mold for injection molding, or the portion where the conductive layer fails to be transferred accounts for less than 20% of the surface of the molded article where the conductive layer should be transferred.
C: The portion where the conductive layer fails to be transferred accounts 20% or more of the surface of the molded article where the conductive layer should be transferred.

(8) Moldability of molding film for in-mold transfer

After opening the mold for injection molding in the procedure described in (7), the molding film for in-mold transfer was visually observed before peeling off the substrate film from the molding film for in-mold transfer and evaluations were made according to the following criteria.

A: The conductive layer and the substrate film conform to the shape of the molded article. This is rated as "good".
B: The conductive layer and the substrate film conform to the shape of the molded product, but the conductive layer or the substrate film partly suffers cracking. This is rated as "practically acceptable".
C: The conductive layer and the substrate film fail to conform to the shape of the molded product. Or the conductive layer or the substrate film suffers cracking. This is rated as "practically unacceptable".

(9) Thickness unevenness in conductive layer

For the evaluation of the unevenness in thickness of the conductive layer, the molded article produced by the procedure described in (7) was cut perpendicularly to the thickness of the molded article at five randomly selected points using a manual type rotary microtome (HistoCore BIOCUT (registered trademark) R, manufactured by Leica Microsystems) to prepare a cross section of the molded article, and the cross section of the conductive layer was observed using a scanning electron microscope (XL30 SFEG, manufactured by FEI Company) at an accelerating voltage of 20 kV and an observation magnification of 100,000x. The standard deviation of the measurements obtained was calculated, and evaluations were made according to the criteria given below.

A: The standard deviation is 1.5 or less. This is rated as "good".
B: The standard deviation is larger than 1.5 and 2.5 or less. This is rated as "practically acceptable".
C: The standard deviation is larger than 2.5. This is rated as "practically unacceptable".

(10) In-plane variation in electromagnetic wave shielding capability

Measurements were taken by the KEC method (electric field) at five randomly selected points on a molded article produced by the procedure described in (7), and the electromagnetic wave shielding capability (dB) at a frequency of 300 MHz was calculated by a spectrum analyzer. Based on the measurements taken, evaluations were made according to the criteria given below.

A: The difference between the maximum and minimum values is 5 or less. This is rated as "good".
B: The difference between the maximum and minimum values is larger than 5 and 10 or less. This is rated as "practically acceptable".
C: The difference between the maximum and minimum values is larger than 10. This is rated as "practically unacceptable".

The materials used were as listed below.

(Silicone Resin A)

Alkyd modified silicone resin (X-62-900B, manufactured by Shin-Etsu Chemical Co., Ltd.)

(Silicone Resin B)

Addition reaction type silicone resin (DOWSIL (registered trademark) LTC750A, manufactured by Dow Toray Co., Ltd.).

(Particles A)

Silver particles (AgG-204B, manufactured by Fukuda Metal Foil & Powder Co., Ltd., average particle diameter 1.8 $\mu$m, kidney-like shape, aspect ratio 2.2)

(Particles B)

Silver particles (AG-2-1C, manufactured by Dowa Electronics Materials Co., Ltd., average particle diameter 0.8

μm, spherical shape, aspect ratio 1.0)

(Polyester resin A)

Saturated copolyester resin (Elitel (registered trademark) XA-0847, manufactured by Unitika Ltd., glass transition temperature 58°C, weight average molecular weight 8,000, acid value 10 mg/KOH)

(Polyester resin B)

Urethane modified polyester resin (VYLON (registered trademark) UR-4800, manufactured by Toyobo Co., Ltd., glass transition temperature 106°C, weight average molecular weight 25,000, acid value 4 mg/KOH)

(Polyester resin C)

Saturated copolyester resin (Elitel (registered trademark) UE-3320, manufactured by Unitika Ltd., glass transition temperature 38°C, weight average molecular weight 1,800, acid value 1 mg/KOH)

(Polyester resin D)

Saturated copolyester resin (VYLON (registered trademark) GK-810, manufactured by Toyobo Co., Ltd., glass transition temperature 46°C, weight average molecular weight 6,000, acid value 5 mg/KOH)

(Polyester resin E)

Saturated copolyester resin (Elitel (registered trademark) KA-5034, manufactured by Unitika Ltd., glass transition temperature 67°C, weight average molecular weight 9,000, acid value 7 mg/KOH)

(Acrylic resin)

Acrylic resin (8DL-100, manufactured by Taisei Fine Chemical Co., Ltd., glass transition temperature 90°C, weight average molecular weight 8,000, acid value 1 mg/KOH)

(Injection resin A)

Polybutylene terephthalate resin (Toraycon (registered trademark) 1101G, manufactured by Toray Industries, Inc.)

(Injection resin B)

Polyacrylonitrile-butadiene-styrene resin (Toyolac (registered trademark) 100, manufactured by Toray Industries, Inc.)

[Example 1]

<Preparation of release layer lamination film>

The materials to use as components for a release layer specified in Table 1 were dissolved in methyl ethyl ketone, and then mixed and dispersed using a Homodisper (manufactured by Primix Corporation) to prepare a coating composition for a release layer with a solid content of 3.0 mass%. This coating composition for a release layer was spread by the gravure coating technique over a substrate film, which was a biaxially oriented polyethylene terephthalate film (Lumirror (registered trademark) S10, manufactured by Toray Industries, Inc.,) having a thickness of 38 μm, and dried at 120°C to provide a release layer lamination film having a release layer with a thickness of 0.05 μm, which was wound into a roll.

<Production of molding film for in-mold transfer>

Materials for preparing a conductive layer were prepared as shown in Table 1, dispersed or dissolved in DMEA, used as an organic solvent, and kneaded in a three-roll mill to provide a resin mixture for a conductive layer. Next, the resin mixture and ethyl methyl ketone were mixed and dispersed using a Homodisper (manufactured by Primix Corporation) to prepare a coating composition for a conductive layer with a solid content of 30.0 mass%. This composition for a conductive layer was spread on the release layer side of the release layer lamination film by the gravure coating technique, and dried at 120°C to lay a conductive layer with a thickness of 10 μm. Furthermore, a coating composition for an adhesive layer (K588HP, a vinyl chloride-vinyl acetate copolymer adhesive, manufactured by Toyo Ink Co., Ltd.) was laid by the gravure coating technique, dried, and cured to lay an adhesive layer with a thickness of 10 μm, thus providing a molding film for in-mold transfer, which was then wound into a roll.

<Preparation of molded article>

A molded article was produced by the procedure described in "(7) Processability in molding step". The resulting conductive layer, resin, molding film for in-mold transfer, and molded article were examined for various evaluation items. Results of the evaluations are shown in Table 1.

[Examples 2 to 11 and Comparative examples 1 to 3]

Except for using the release layers, particles, resins, injection resins, and adhesive layers specified in Tables 1 and 2, the same procedures as in Example 1 were carried out to prepare molding films for in-mold transfer and produce molded articles. It should be noted that no release layer is provided in Comparative example 1. Results of the evaluations of molding films for in-mold transfer and molded articles are shown in Table 1 and Table 2.

[Table 1]

[Table 1]

| | | | Example 1 | Example 2 | Example 3 | Example 4 | Example 5 | Example 6 | Example 7 |
|---|---|---|---|---|---|---|---|---|---|
| components of release layer | silicone resin (mass%) | A | 100 | | 100 | 100 | 100 | 100 | 100 |
| | | B | | 100 | | | | | |
| components of conductive layer | particles (mass%) | A | 85 | 85 | 85 | 90 | 65 | 85 | 85 |
| | | B | | | | | | | |
| | resin | polyester resin (mass%) | A | 15 | 15 | | 10 | 35 | 15 | |
| | | | B | | | | | | | |
| | | | C | | | | | | | |
| | | | D | | | | | | | 15 |
| | | | E | | | | | | | |
| | | acrylic resin (mass%) | | | 15 | | | | |
| thickness of conductive layer ($\mu$m) | | | 10 | 10 | 10 | 10 | 10 | 6 | 10 |
| thickness of adhesive layer ($\mu$m) | | | 10 | 10 | 10 | 10 | 10 | 10 | 10 |
| aspect ratio of particles | first type particles | | | | | | | | |
| | second type particles | | 2.2 | 2.2 | 2.2 | 2.2 | 2.2 | 2.2 | 2.2 |
| glass transition temperature of conductive layer (°C) | | | 58 | 58 | 90 | 58 | 58 | 58 | 46 |
| weight average molecular weight of resin | | | 8,000 | 8,000 | 8,000 | 8,000 | 8,000 | 8,000 | 6,000 |
| electromagnetic wave shielding capability of molding film for in-mold transfer (dB) | | | 55 | 55 | 55 | 60 | 42 | 41 | 55 |
| electromagnetic wave shielding capability of molding film for in-mold transfer extended ×1.1 in length and ×1.1 in width (dB) | | | 50 | 50 | 50 | 55 | 37 | 36 | 50 |
| processability in molding step | molding resin A | | A | B | A | A | A | A | A |
| | molding resin B | | A | B | A | A | A | A | A |
| moldability of molding film for in-mold transfer | molding resin A | | A | A | B | B | A | A | A |
| | molding resin B | | A | A | B | A | A | A | A |

EP 4 541 586 A1

14

|  |  | Example 1 | Example 2 | Example 3 | Example 4 | Example 5 | Example 6 | Example 7 |
|---|---|---|---|---|---|---|---|---|
| thickness unevenness in conductive layer | molding resin A | A | A | A | A | A | A | B |
| | molding resin B | A | A | A | A | A | A | B |
| in-plane variation in electromagnetic wave shielding capability | molding resin A | A | A | A | A | A | A | B |
| | molding resin B | A | A | A | A | A | A | B |

[Table 2]

[Table 2]

[Table 2]

| | | | Example 8 | Example 9 | Example 10 | Example 11 | Comparative example 1 | Comparative example 2 | Comparative example 3 |
|---|---|---|---|---|---|---|---|---|---|
| components of release layer | silicone resin (mass%) | A | 100 | 100 | 100 | 100 | | 100 | 100 |
| | | B | | | | | | | |
| components of conductive layer | particles (mass%) | A | 85 | 50 | 40 | 85 | 85 | 85 | 85 |
| | | B | | 35 | 45 | | | | |
| | resin | polyester resin (mass%) | A | | 15 | 15 | 15 | 15 | | |
| | | | B | | | | | | 15 | |
| | | | C | | | | | | | 15 |
| | | | D | | | | | | | |
| | | | E | 15 | | | | | | |
| | | acrylic resin (mass%) | | | | | | | | |
| thickness of conductive layer (μm) | | | 10 | 10 | 10 | 10 | 10 | 10 | 10 |
| thickness of adhesive layer (μm) | | | 10 | 10 | 10 | | 10 | 10 | 10 |
| aspect ratio of particles | first type particles | | | 1.0 | 1.0 | | | | |
| | second type particles | | 2.2 | 2.2 | 2.2 | 2.2 | 2.2 | 2.2 | 2.2 |
| glass transition temperature of conductive layer (°C) | | | 67 | 58 | 58 | 58 | 58 | 106 | 38 |
| weight average molecular weight of resin | | | 9,000 | 8,000 | 8,000 | 8,000 | 8,000 | 25,000 | 1,800 |
| electromagnetic wave shielding capability of molding film for in-mold transfer (dB) | | | 55 | 55 | 50 | 55 | 55 | 55 | 55 |
| electromagnetic wave shielding capability of molding film for in-mold transfer longitudinal extended ×1.1 in length and ×1.1 in width (dB) | | | 50 | 54 | 40 | 50 | 45 | 1 | 40 |
| processability in molding step | molding resin A | | A | A | A | B | C | A | A |
| | molding resin B | | A | A | A | B | C | A | A |
| moldability of molding film for in-mold transfer | molding resin A | | B | A | A | A | A | C | A |
| | molding resin B | | B | A | A | A | A | C | A |

EP 4 541 586 A1

EP 4 541 586 A1

(continued)

|  | | Example 8 | Example 9 | Example 10 | Example 11 | Comparative example 1 | Comparative example 2 | Comparative example 3 |
|---|---|---|---|---|---|---|---|---|
| thickness unevenness in conductive layer | molding resin A | A | A | A | A | A | A | C |
| | molding resin B | A | A | A | A | A | A | C |
| in-plane variation in electromagnetic wave shielding capability | molding resin A | A | A | A | A | A | A | C |
| | molding resin B | A | A | A | A | A | A | C |

18

**Claims**

1. A molding film for in-mold transfer comprising a substrate film, a release layer, and a conductive layer disposed in this order, wherein the conductive layer contains particles in an amount of 60 mass% or more and 91 mass% or less in 100 mass% of the conductive layer, the conductive layer also containing resin in an amount of 9 mass% or more and 40 mass% or less, the resin having a weight average molecular weight of 5,000 or more and less than 10,000, and the particles being made of one or more substances selected from the group consisting of zero-valent carbon, silver, gold, copper, nickel, chromium, palladium, indium, aluminum, zinc, and platinum.

2. The molding film for in-mold transfer according to claim 1, wherein the conductive layer has a thickness of 5 μm or more and 15 μm or less.

3. The molding film for in-mold transfer according to either claim 1 or 2, wherein the conductive layer exhibits a glass transition temperature of 40°C or more and 100°C or less when heated from 20°C to 250°C at a rate of 20°C/min in a nitrogen atmosphere using a differential scanning calorimeter.

4. The molding film for in-mold transfer according to either claim 1 or 2, comprising the substrate film, the release layer, the conductive layer, and an adhesive layer disposed in this order.

5. The molding film for in-mold transfer according to either claim 1 or 2, wherein the release layer contains silicone resin as primary component.

6. The molding film for in-mold transfer according to claim 5, wherein the release layer contains an alkyd modified silicone resin as primary component.

7. The molding film for in-mold transfer according to either claim 1 or 2, wherein the resin is polyester resin.

8. The molding film for in-mold transfer according to claim 7, wherein the polyester resin has an acid value of 5 mgKOH/g or more and 20 mgKOH/g or less.

9. The molding film for in-mold transfer according to either claim 1 or 2, wherein the particles include first type particles having an aspect ratio of 1 or more and less than 2 and second type particles having an aspect ratio of 2 or more.

10. The molding film for in-mold transfer according to either claim 1 or 2, showing an electromagnetic wave shielding capability of 40 dB or more when the molding film for in-mold transfer is examined by the KEC method (electric field) for electromagnetic waves with a frequency of 300 MHz.

11. The molding film for in-mold transfer according to either claim 1 or 2, wherein the substrate film is a polyethylene terephthalate film.

12. A production method for molded articles comprising a step for placing the molding film for in-mold transfer according to either claim 1 or 2 in a mold cavity and then injecting a molding resin and/or a molding resin precursor.

## INTERNATIONAL SEARCH REPORT

International application No.

**PCT/JP2023/018267**

### A. CLASSIFICATION OF SUBJECT MATTER

*B32B 27/18*(2006.01)i; *B29C 45/14*(2006.01)i; *H05K 9/00*(2006.01)i
FI: B32B27/18 J; H05K9/00 Q; H05K9/00 W; B29C45/14

According to International Patent Classification (IPC) or to both national classification and IPC

### B. FIELDS SEARCHED

Minimum documentation searched (classification system followed by classification symbols)

B32B1/00-43/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2012-201016 A (TOYO INK SC HOLDINGS CO., LTD.) 22 October 2012 (2012-10-22) | 1-12 |
| A | JP 2018-69525 A (TOPPAN PRINTING CO., LTD.) 10 May 2018 (2018-05-10) | 1-12 |
| A | JP 2021-192960 A (TOYO INK SC HOLDINGS CO., LTD.) 23 December 2021 (2021-12-23) | 1-12 |
| A | WO 2020/137284 A1 (FUJIFILM CORP.) 02 July 2020 (2020-07-02) | 1-12 |
| A | WO 2020/203659 A1 (DAINIPPON PRINTING CO., LTD.) 08 October 2020 (2020-10-08) | 1-12 |

☐ Further documents are listed in the continuation of Box C.  ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **11 July 2023** | **25 July 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/018267**

| Patent document cited in search report | | | Publication date (day/month/year) | Patent family member(s) | | | Publication date (day/month/year) |
|---|---|---|---|---|---|---|---|
| JP | 2012-201016 | A | 22 October 2012 | (Family: none) | | | |
| JP | 2018-69525 | A | 10 May 2018 | (Family: none) | | | |
| JP | 2021-192960 | A | 23 December 2021 | (Family: none) | | | |
| WO | 2020/137284 | A1 | 02 July 2020 | CN | 113316743 | A | |
| | | | | TW | 202036602 | A | |
| WO | 2020/203659 | A1 | 08 October 2020 | EP | 3950341 | A1 | |
| | | | | CN | 113631383 | A | |

Form PCT/ISA/210 (patent family annex) (January 2015)

**EP 4 541 586 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021192960 A, Kokai
- JP 2006297642 A, Kokai
- US 2681294 A